# EUROPÄISCHE PATENTSCHRIFT

(11) **EP 2 607 857 B1**
(45) Veröffentlichungstag und Bekanntmachung des Hinweises auf die Patenterteilung: **25.07.2018**
(21) Anmeldenummer: 12008388.6
(22) Anmeldetag: 17.12.2012
(51) Int. Cl.: G01D 5/14, G01D 11/24

(54) **Integrierter Magnetfeldsensor und Verfahren für eine Messung der Lage eines ferromagnetischen Werkstückes mit einem integrierten Magnetfeldsensor**
Integrated magnetic field sensor and method for measuring the position of a ferromagnetic workpiece with an integrated magnetic field sensor
Capteur de champ magnétique intégré et procédé de mesure de la position d'une pièce à usiner ferromagnétique équipée d'un capteur de champ magnétique intégré

(30) Priorität: 19.12.2011 DE 102011121298
(43) Veröffentlichungstag der Anmeldung: 26.06.2013
(73) Patentinhaber: TDK-Micronas GmbH, 79108 Freiburg (DE)
(72) Erfinder: Heberle, Klaus, 79312 Emmendingen (DE)
(74) Vertreter: Koch Müller Patentanwaltsgesellschaft mbH

(56) Entgegenhaltungen:
- FR-A1- 2 852 098
- US-A1- 2006 261 801
- US-A1- 2009 140 725

## Beschreibung

Die Erfindung betrifft einen integrierten Magnetfeldsensor gemäß dem Oberbegriff des Patentanspruchs 1 und ein Verfahren für eine Ermittlung der Lage eines ferromagnetischen Werkstückes mit einem integrierten Magnetfeldsensor gemäß dem Oberbegriff des Patentanspruchs 7.

Aus der WO 2010 / 060607 A2 ist ein IC - Gehäuse mit einem Halbleiterchip mit einer integrierten Schaltung und einem integrierten magnetischen Sensor bekannt. Von dem Gehäuse des Halbleiterchips beabstandet ist ein Permanentmagnet, dessen magnetischer Fluss den Sensor durchdringt. Nähert sich am kopfseitigen Ende des Halbleiterchips ein zu messender Gegenstand, ändert sich die magnetische Flussdichte durch den Sensor. Es ist wünschenswert die aufwändige Anordnung und deren Empfindlichkeit zu verbessern.

Des Weiteren sind aus der EP 1 436 849 B1, der US 2009 / 140 725 A1 entsprechend der DE 10 2008 058 895 A1, der US 2006 / 261 801 A1 und der US 2010 / 021 98 10 A1 Anordnungen mit Magnetfeldsensoren bekannt.

Aus der DE 10 2004 010 126 A1 und der US 7 250 760 B2 sind integrierte magnetischer Hallsensoren bekannt, bei denen in dem IC-Gehäuse ein Permanentmagnet mit eingeordnet ist. Hierbei sind die Hallsensoren derart zu dem Feld der Permanentmagneten angeordnet, dass ohne äußere Feldbeeinflussung eine Hallspannung erzeugt wird.

Aus der DE 698 27 559 T2 ist eine integrierte Halleffektsensoreinheit bekannt, bei der ein Hallsensor oberhalb und ein Permanentmagnet unterhalb eines metallischen Trägers, der auch als Leadframe bezeichnet wird, angeordnet ist. Die einzelnen Komponenten sind in einem einzigen IC-Gehäuse angeordnet. Der Permanentmagnet ist innerhalb des IC-Gehäuses so angeordnet, dass sich das ergebende Magnetfeld senkrecht zu dem integrierten Hallsensor ist. Anders ausgedrückt, verlaufen die Magnetfeldlinien im Wesentlich senkrecht zu einer Haupterstreckungsebene des Hallsensor und erzeugen ohne äußere Feldbeeinflussung eine Hallspannung. Bei einer Anordnung eines, außerhalb des IC-Gehäuses ausgebildeten ferromagnetischen Bauteils, unmittelbar oberhalb der Haupterstreckungsrichtung des Hallsensors verringert sich im Vergleich ohne ferromagnetisches Bauteil die Reluktanz und die Hallspannung wird erhöht.

Vor diesem Hintergrund besteht die Aufgabe der Erfindung darin, eine Vorrichtung anzugeben, die den Stand der Technik weiterbildet.

Die Aufgabe wird durch einen integrierten Magnetfeldsensor mit den Merkmalen des Patentanspruchs 1 und durch ein Verfahren für eine Ermittlung der Lage eines ferromagnetischen Werkstückes mit einem integrierten Magnetfeldsensor mit den Merkmalen des Patentanspruchs 7 gelöst. Vorteilhafte Ausgestaltungen der Erfindung sind Gegenstand von Unteransprüchen.

Gemäß dem ersten Gegenstand der Erfindung wird ein integrierter Magnetfeldsensor mit den Merkmalen des Anspruchs 1 offenbart.

Es sei angemerkt, dass aufgrund der geometrischen Ausrichtung des Hallsensors zu dem Magneten, im Folgenden auch als Permanentmagneten bezeichnet, ohne äußere Beeinflussung mittels eines ferromagnetischen Bauteils nur eine sehr geringe Hallspannung oder keine Hallspannung an dem Hallsensor anliegt. Es versteht sich, dass der Magnet in der unmittelbaren Nähe des Hallsensors vorzugsweise mit einem Abstand unterhalb 10 mm, vorzugsweise unterhalb 2 mm, höchst vorzugsweise unterhalb 0,7 mm, anzuordnen ist. Unter dem Abstand wird hierbei die Entfernung von einer Fläche des Magneten bis zu dem Flächenschwerpunkt der Haupterstreckungsfläche verstanden wird.

Gemäß dem zweiten Gegenstand der Erfindung wird ein Verfahren für eine Ermittlung der Lage eines ferromagnetischen Bauteils mit einem integrierten Magnetfeldsensor mit den Merkmalen des Anspruchs 7 offenbart.

Ein Vorteil der erfindungsgemäßen Vorrichtung und des Verfahrens ist es, dass sich durch die Kombination eines Halbleiterkörpers, auch Die genannt, mit einem Permanentmagneten auf einen gemeinsamen Metallträger, auch Leadframe genannt, und des zu der Haupterstreckungsebene parallelen Verlaufs der magnetischen Feldlinien die Empfindlichkeit des integrierten Magnetfeldsensors hinsichtlich der Detektion einer Änderung der magnetischen Flussdichte geändert wird. Ein Grund hierfür ist, dass mittels des sehr geringen Abstandes zwischen Hallsensor und Permanentmagnet und der räumlichen vorteilhaften Ausrichtung der Haupterstreckungsfläche des Hallsensors und dem Permanentmagneten vorzugsweise erst dann und höchst vorzugsweise nur dann eine Hallspannung erzeugt wird, wenn ein in der Nähe außerhalb des Gehäuses angeordnetes ferromagnetisches Bauteil die Flussdichte in dem Hallsensor geändert.

Gemäß einer Weiterbildung wird bei der Ablenkung der magnetischen Feldlinien die Hallspannung vergrößert. Untersuchungen haben gezeigt, dass bereits eine geringe Annäherung eines ferromagnetischen Bauteils zu einer Erzeugung einer Hallspannung führt. Aus dem Vorzeichen und der Stärke lässt sich der Ort des ferromagnetischen Bauteils bestimmen. Um die Genauigkeit der Bestimmung zu erhöhen, ist es vorteilhaft, vor einer Ermittlung eine Kalibrierung mit dem zu ermittelnden Bauteil durchzuführen und die von dem Ort bzw. von der Lage des ferromagnetischen Bauteils abhängigen Hallspannungen zu ermitteln und in einem Kennlinienfeld abzulegen.

In einer anderen Ausführungsform weist der Hallsensor eine orthogonal zu der Haupterstreckungsebene ausgebildete Seitenfläche auf, wobei die Mittelachse des Permanentmagneten senkrecht auf der Seitenfläche angeordnet ist. Vorteilhaft ist, wenn der Permanentmagnet auf der Vorderseite des Metallträgers ausgebildet ist. Hierbei lässt sich zwischen dem Permanentmagneten und dem Hallsensor ein besonders geringer Abstand, vorzugsweise unterhalb 1 mm erreichen, d.h. die magnetische Flussdichte durch den Hallsensor ist besonders hoch. Hierdurch lässt sich die Empfindlichkeit der Vorrichtung bzw. des Verfahrens erhöhen, indem bereits eine kleine Beeinflussung, d. h. Abweichung von der Parallelität und zu einer merklichen Hallspannung führt.

Gemäß einer anderen Weiterbildung ist der Hallsensor als 1-dimensionaler oder 2-dimensionaler oder 3-demsinonaler Hallsensor ausgebildet. Vorzugsweise sind die Hallsensoren in den einzelnen Dimensionen zueinander orthogonal ausgerichtet. Es versteht sich, dass gemäß einer ersten Alternative bei einer 2-dimensonalen Ausbildung beide Haupterstreckungsflächen derart zu dem Verlauf der magnetischen Feldlinien ausgerichtet sind, dass im Wesentlichen nur dann eine Hallspannung erzeugt wird, wenn die magnetischen Feldlinien mittels des ferromagnetischen Bauteils abgelenkt werden. In einer zweiten alternativen Ausführungsform ist bei dem 2-dimesionalen oder bei dem 3-dimesionalen Hallsensor eine der Haupterstreckungsflächen des Hallsensors derart zu einem Pol des Magneten ausgerichtet, dass eine Hallspannung in einer der Hallsensoren erzeugt wird. Anders ausgedrückt, der Hallsensor ist in einer zweiten Dimension derart zu dem ersten Pol des Magneten angeordnet, dass eine Hallspannung auch ohne das ferromagnetische Bauteil erzeugt wird. Hierdurch lässt sich sowohl die Feldstärke des Permanentmagneten bestimmen als auch die Detektionsgenauigkeit der Sensoranordnung erhöhen.

In einer bevorzugten Ausführungsform ist der Hallsensor als Hallplatte ausgebildet. Vorzugsweise weist bei einer 2-dimensionalen oder bei einer 3-dimensionalen Ausführung der Halssensor 2 bzw. 3 zueinander orthogonal ausgebildete Hallplatten auf.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnitt auf eine erste erfindungsgemäße Ausführungsform eines integrierten Magnetfeldsensors,
- Figur 2: eine Querschnitt auf eine zweite erfindungsgemäße Ausführungsform eines integrierten Magnetfeldsensors,
- Figur 3: eine Querschnitt auf eine dritte erfindungsgemäße Ausführungsform eines integrierten Magnetfeldsensors.

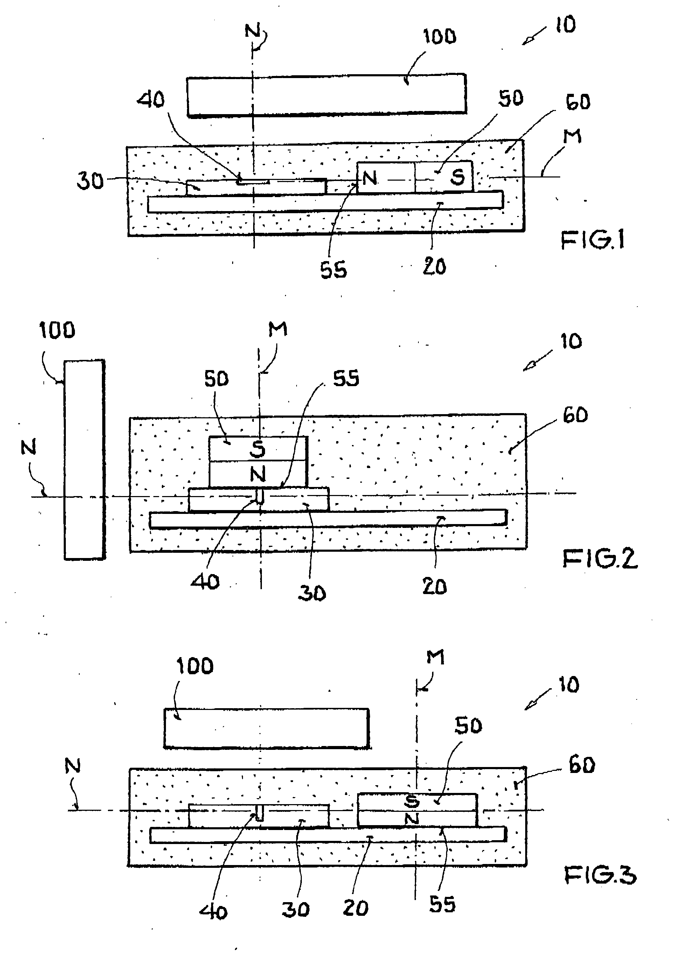

Die Abbildung der Figur 1 zeigt eine erste erfindungsgemäße Ausführungsform eines integrierten Magnetfeldsensors 10, aufweisend einen Metallträger 20, mit einer Vorderseite und einer Rückseite und einen auf der Vorderseite des Metallträgers 20 angeordneten Halbleiterkörper 30, mit einer Oberfläche und einer Rückfläche. Der Halbleiterkörper 30 ist mit der Rückfläche mit der Vorderseite des Metallträgers kraftschlüssig verbunden. An der Oberfläche weist der Halbleiterkörper 30 einen Hallsensor 40 auf. Der Hallsensor 40, der vorzugsweise als Hallplatte ausgeführt ist, weist eine parallel zu der Oberfläche des Halbleiterkörpers 30 verlaufende Haupterstreckungsfläche auf. Ferner ist auf der Vorderseite des Metallträgers 20 ein Magnet 50 angeordnet. Der Magnet 50 weist einen entlang einer ersten Fläche 55 ausgebildeten ersten magnetischen Nordpol und eine senkrecht auf der ersten Fläche 55 ausgebildete Mittelachse M auf. Die erste Fläche 55 des Magneten 50 ist senkrecht zur Haupterstreckungsfläche des Hallsensors 40 ausgebildet. Des Weiteren verläuft die Mittelachse M parallel zu der Haupterstreckungsebene des Hallsensors 40. Vorzugsweise trifft die Mittelachse M senkrecht auf die Normale N der Haupterstreckungsfläche in dem Flächenschwerpunkt der Haupterstreckungsfläche, so dass die Feldlinien des Magneten 50 im Wesentlichen parallel zu der Haupterstreckungsfläche des Hallsensors 40 verlaufen. Es versteht sich, dass die Normale N im Wesentlichen, vorzugsweise genau in dem Ftächenschwerpunkt der Haupterstreckungsfläche angeordnet ist. Der Metallträger 20, der Magnet 50 und der Halbleiterkörper 30 sind in einem gemeinsamen einzigen Gehäuse 60 angeordnet. In dem Gehäuse 60 ist genau ein oder mindestens ein Hallsensor angeordnet. Außerhalb des Gehäuses 60 oberhalb der Oberfläche des Halbleiterkörpers 30 ist ein ferromagnetisches Bauteil 100 vorgesehen.

Mittels des ferromagnetischen Bauteils 100 werden vorliegend die magnetischen Feldlinien senkrecht zu der Haupterstreckungsebene des Hallsensors abgelenkt und hierdurch wird eine Hallspannung erzeugt. Es sei angemerkt, dass das Vorzeichen der Hallspannung von der Lage des ferromagnetischen Bauteils 100 zu der Haupterstreckungsebene des Hallsensors 40 und des Magneten 50 abhängt. Anders ausgedrückt, vergrößert sich bei einer Annäherung des Bauteils an das Gehäuse die Hallspannung betragsmäßig.

Die Abbildung der Figur 2 zeigt einen Querschnitt auf eine zweite erfindungsgemäße Ausführungsform eines integrierten Magnetfeldsensors 10. Im Folgenden werden nur die Unterschiede zu der Ausführungsform der Figur 1 erläutert. Die erste Fläche 55 des Magneten 50 ist auf der Oberseite des Halbleiterkörpers 30 vorzugsweise zentrisch justiert angeordnet. Hierbei trifft die Mittelsachse M des Magneten 50 im Wesentlichen senkrecht auf die Normale N der Haupterstreckungsfläche des Hallsensors 40. Die Normale N ist im Wesentlichen, vorzugsweise genau, in dem Flächenschwerpunkt der Haupterstreckungsfläche des Hallsensors 40 angeordnet. Das ferromagnetische Bauteil 100 ist an einer Stirnseite des Gehäuses 60 angeordnet. Hierdurch werden die magnetischen Feldlinien derart abgelenkt, dass eine Hallspannung erzeugt wird.

Die Abbildung der Figur 3 zeigt einen Querschnitt auf eine dritte erfindungsgemäße Ausführungsform eines integrierten Magnetfeldsensors 10. Im Folgenden werden nur die Unterschiede zu den vorstehenden Ausführungsformen erläutert. Die erste Fläche 55 des Magneten 50 ist auf der Vorderseite des Metallträgers 20 kraftschlüssig angeordnet. Es ist bevorzugt, die Normale N in der Höhe der Verbindungsschicht zwischen den beiden Polen des Magneten anzuordnen. Hierbei trifft die Mittelachse M des Magneten 50 im Wesentlichen senkrecht auf die Normale N der Haupterstreckungsfläche des Hallsensors 40. Die Normale N ist im Wesentlichen, vorzugsweise genau in dem Flächenschwerpunkt der Haupterstreckungsfläche des Hallsensors 40 angeordnet. Das ferromagnetische Bauteil 100 ist außerhalb des Gehäuses 60 oberhalb der Oberfläche des Halbleiterkörpers 30 angeordnet. Hierdurch werden die magnetischen Feldlinien derart abgelenkt, dass eine Hallspannung erzeugt wird. Es sei angemerkt, der Hallsensor 40 als mehrdimensionaler Hallsensor (40) ausgebildet ist, wobei die einzelnen Dimensionen des Halssensors (40) zueinander orthogonal ausgerichtet sind.

## Patentansprüche

1. Integrierter Magnetfeldsensor (10), aufweisend
einen Halbleiterkörper (30) mit einer Oberfläche und einer Rückfläche, einen Metallträger (20), mit einer Vorderseite und einer Rückseite, wobei der Halbleiterkörper (30) mit der Rückfläche mit der Vorderseite des Metallträgers (20) kraftschlüssig verbunden ist,
genau einen Hallsensor (40), ausgebildet an der Oberfläche des Halbleiterkörpers (30), mit einer Haupterstreckungsfläche,
einen Permanentmagneten (50), mit einem entlang einer ersten Fläche (55) ausgebildeten ersten magnetischen Pol und einer senkrecht auf der ersten Fläche (55) ausgebildeten Mittelachse (M), wobei der Metallträger (20), der Permanentmagnet (50) und der Halbleiterkörper (30) in einem gemeinsamen Gehäuse (60) angeordnet sind und in dem Gehäuse (60) der Hallsensor (40) angeordnet ist, und
die erste Fläche (55) des Permanentmagneten (50) senkrecht zur Haupterstreckungsfläche des einzigen Hallsensors (40) ausgebildet ist,
die Mittelachse (M) des Permanentmagneten (50) parallel zu der Haupterstreckungsebene des Hallsensors (40) verläuft und die Mittelachse (M) senkrecht durch eine Normale (N) der Haupterstreckungsfläche tritt, wobei die Normale (N) in dem Flächenschwerpunkt der Haupterstreckungsfläche steht und die Feldlinien des Permanentmagneten (50) im Wesentlichen parallel zu der Haupterstreckungsfläche des Hallsensors (40) verlaufen, so dass eine Hallspannung erzeugt wird, wenn mittels eines ferromagnetischen Bauteils (100) ein Teil der magnetischen Feldlinien senkrecht zu der Haupterstreckungsebene des Hallsensors (40) abgelenkt werden und in einer ersten Ausführungsform der Permanentmagnet (50) nur auf der Vorderseite des Metallträgers (20) ausgebildet ist, wobei die Mittelachse (M) des Permanentmagneten (50) innerhalb der Haupterstreckungsfläche des Hallsensors (40) verläuft oder
- die Normale (N) innerhalb einer Verbindungsschicht zwischen den beiden Polen des Magneten verläuft,
oder in einer zweiten Ausführungsform der Permanentmagnet (50) nur auf der Oberfläche des Halbleiterkörpers (30) ausgebildet ist, wobei die Mittelachse (M) des Permanentmagneten (50) innerhalb der Haupterstreckungsfläche des Hallsensors (40) verläuft.

2. Integrierter Magnetfeldsensor (10) nach Anspruch 1, **dadurch gekennzeichnet, dass** sich bei der Ablenkung der magnetischen Feldlinien die Hallspannung vergrößert.

3. Integrierter Magnetfeldsensor (10) nach Anspruch 1 oder Anspruch 2, **dadurch gekennzeichnet, dass** der Hallsensor (40) eine orthogonal zu der Haupterstreckungsebene ausgebildete Seitenfläche aufweist und die Mittelachse (M) des Magneten senkrecht auf der Seitenfläche angeordnet ist.

4. Integrierter Magnetfeldsensor (10) nach einem der vorstehenden Ansprüche, **dadurch gekennzeichnet, dass** der Hallsensor (40) als 2-dimensionaler oder 3-dimensionaler Hallsensor ausgebildet ist.

5. Integrierter Magnetfeldsensor (10) nach Anspruch 5, **dadurch gekennzeichnet, dass** der Hallsensor (40) in einer zweiten Dimension derart zu dem ersten Pol des Permanentmagneten (50) ausgebildet ist, dass eine Hallspannung auch ohne das ferromagnetische Bauteil (100) erzeugt ist.

6. Integrierter Magnetfeldsensor (10) nach einem der vorstehenden Ansprüche, **dadurch gekennzeichnet, dass** der Hallsensor (40) als Hallplatte ausgebildet ist.

7. Verfahren für eine Ermittlung der Lage eines ferromagnetischen Bau-teils (100) mit einem integrierten Magnetfeldsensor (10), aufweisend einen Halbleiterkörper (30) mit einer Oberfläche und einer Rückfläche, einen Metallträger (20), mit einer Vorderseite und einer Rückseite, wobei der Halbleiterkörper (30) mit der Rückfläche mit der Vorderseite des Metallträgers (20) kraftschlüssig verbunden ist,
einen Hallsensor (40), ausgebildet an der Oberfläche des Halbleiterkörpers (30), mit einer Haupterstreckungsfläche,
einen Permanentmagneten (50), mit einem entlang einer ersten Fläche (55) ausgebildeten ersten magnetischen Pol und einer senkrecht auf der ersten Fläche ausgebildeten Mittelachse (M), wobei der Metallträger (20), der Permanentmagnet (50) und der Halbleiterkörper (30) in einem gemeinsamen Gehäuse (60) angeordnet sind und in dem Gehäuse (60) genau ein Hallsensor (40) angeordnet ist,
die erste Fläche (55) des Permanentmagneten (50) senkrecht zur Haupterstreckungsfläche des Hallsensors (40) ausgebildet ist und die Mittelachse (M) parallel zu der Haupterstreckungsebene des Hallsensors (40) verläuft und die Mittelachse (M) senkrecht durch die Normale der Haupterstreckungsfläche in dem Flächenschwerpunkt der Haupterstreckungsfläche tritt und die Feldlinien des Permanentmagneten (50) im Wesentlichen parallel zu der Haupterstreckungsfläche des Hallsensors (40) verlaufen, so dass eine Hallspannung erzeugt wird, wenn mittels eines ferromagnetischen Bauteils (100) ein Teil der magnetischen Feldlinien senkrecht zu der Haupterstreckungsebene des Hallsensors (40) abgelenkt werden, wobei in einer ersten Ausführungsform der Permanentmagnet (50) nur auf der Vorderseite des Metallträgers (20) ausgebildet ist, und die Mittelachse (M) des Permanentmagneten (50) innerhalb der Haupterstreckungsfläche des Hallsensors (40) verläuft oder die Normale (N) innerhalb einer Verbindungsschicht zwischen den beiden Polen des Magneten verläuft,
oder in einer zweiten Ausführungsform der Permanentmagnet (50) nur auf der Oberfläche des Halbleiterkörpers (30) ausgebildet ist, und die Mittelachse (M) des Permanentmagneten (50) innerhalb der Haupterstreckungsfläche des Hallsensors (40) verläuft.

8. Verfahren nach Anspruch 7, **dadurch gekennzeichnet, dass** eine Hallspannung ausschließlich dann erzeugt wird, wenn die magnetischen Feldlinien abgelenkt werden.

9. Verfahren nach Anspruch 7 oder Anspruch 8, **dadurch gekennzeichnet, dass** die Hallspannung ausschließlich dann erhöht wird, wenn die magnetischen Feldlinien abgelenkt werden.

## Claims

1. Integrated magnetic field sensor (10) comprising
a semiconductor body (30) with a top surface and a back surface,
a metal support (20) with a front side and a rear side, wherein the semiconductor body (30) is frictionally connected by the back surface with the front side of the metal support (20),
exactly one Hall sensor (40), which is formed at the top surface of the semiconductor body (30), with a main dimension surface,
a permanent magnet (50) with a first magnetic pole formed along a first surface (55) and a centre axis (M) formed perpendicularly to the first surface (55),
wherein the metal support (20), the permanent magnet (50) and the semiconductor body (30) are arranged in a common housing (60) and the Hall sensor (40) is arranged in the housing (60), and
the first surface (55) of the permanent magnet (50) is formed perpendicularly to the main dimension surface of the single Hall sensor (40),
the centre axis (M) of the permanent magnet (50) extends parallel to the main dimension plane of the Hall sensor (40) and the centre axis (M) passes perpendicularly through a normal (N) of the main dimension surface, wherein the normal (N) stands in the centre of area of the main dimension surface and the field lines of the permanent magnets (50) extend substantially parallel to the main dimension surface of the Hall sensor (40) so that a Hall voltage is generated when a part of the magnetic field lines is deflected by means of a ferromagnetic component (100) perpendicularly to the main dimension plane of the Hall sensor (40), and in a first form of embodiment the permanent magnet (50) is formed only on the front side of the metal support (20), wherein the centre axis (M) of the permanent magnet (50) extends within the main dimension surface of the Hall sensor (40) or the normal (N) extends within a connecting layer between the two poles of the magnet, or in a second form of embodiment the permanent magnet (50) is formed only on the surface of the semiconductor body (30), wherein the centre axis (M) of the permanent magnet (50) extends within the main dimension surface of the Hall sensor (40).

2. Integrated magnetic field sensor (10) according to claim 1, **characterised in that** the Hall voltage increases when the magnetic field lines are deflected.

3. Integrated magnetic field sensor (10) according to claim 1 or 2, **characterised in that** the Hall sensor (40) has a side surface formed orthogonally to the main dimension plane and the centre axis (M) of the magnet is arranged perpendicularly to the side surface.

4. Integrated magnetic field sensor (10) according to any one of the preceding claims, **characterised in that** the Hall sensor (40) is formed as a two-dimensional or three-dimensional Hall sensor.

5. Integrated magnetic field sensor (10) according to claim 4, **characterised in that** the Hall sensor (40) in a second dimension is so constructed with respect to the first pole of the permanent magnet (50) that a Hall voltage is generated even without the ferromagnetic component (100).

6. Integrated magnetic field sensor (10) according to any one of the preceding claims, **characterised in that** the Hall sensor (40) is constructed as a Hall plate.

7. Method of determining the position of a ferromagnetic component (100) with an integrated magnetic field sensor (10), comprising
a semiconductor body (30) with a top surface and a back surface,
a metal support (20) with a front side and a rear side, wherein the semiconductor body (30) is frictionally connected by the back surface with the front side of the metal support (20),
a Hall sensor (40), which is formed at the top surface of the semiconductor body (30), with a main dimension surface,
a permanent magnet (50) with a first magnetic pole formed along a first surface (55) and a centre axis (M) formed perpendicularly to the first surface (55),
wherein the metal support (20), the permanent magnet (50) and the semiconductor body (30) are arranged in a common housing (60) and exactly one Hall sensor (40) is arranged in the housing (60),
the first surface (55) of the permanent magnet (50) is formed perpendicularly to the main dimension surface of the Hall sensor (40) and the centre axis (M) extends parallel to the main dimension plane of the Hall sensor (40) and the centre axis (M) passes perpendicularly through the normal of the main dimension surface in the centre of area of the main dimension surface and the field lines of the permanent magnets (50) extend substantially parallel to the main dimension surface of the Hall sensor (40) so that a Hall voltage is generated when a part of the magnetic field lines is deflected by means of a ferromagnetic component (100) perpendicularly to the main dimension plane of the Hall sensor (40), wherein in a first form of embodiment the permanent magnet (50) is formed only on the front side of the metal support (20) and the centre axis (M) of the permanent magnet (50) extends within the main dimension surface of the Hall sensor (40) or the normal (N) extends within a connecting layer between the two poles of the magnet or in a second form of embodiment the permanent magnet (50) is formed only on the surface of the semiconductor body (30) and the centre axis (M) of the permanent magnet (50) extends within the main dimension surface of the Hall sensor (40).

8. Method according to claim 7, **characterised in that** a Hall voltage is generated exclusively when the magnetic field lines are deflected.

9. Method according to claim 7 or claim 8, **characterised in that** the Hall voltage is increased exclusively when the magnetic field lines are deflected.

## Revendications

1. Capteur de champ magnétique intégré (10), présentant
un corps semi-conducteur (30) avec une face supérieure et une face arrière,
un support métallique (20), avec un côté avant et un côté arrière, dans lequel le corps semi-conducteur (30) est assemblé par adhérence par la face arrière au côté avant du support métallique (20),
exactement un capteur de Hall (40), formé sur la face supérieure du corps semi-conducteur (30), avec une face d'extension principale,
un aimant permanent (50), avec un premier pôle magnétique formé le long d'une première face (55) et un axe central (M) formé perpendiculairement à la première face (55),
dans lequel le support métallique (20), l'aimant permanent (50) et le corps semi-conducteur (30) sont disposés dans un boîtier commun (60) et le capteur de Hall (40) est disposé dans le boîtier (60), et
la première face (55) de l'aimant permanent (50) est formée perpendiculairement à la face d'extension principale de l'unique capteur de Hall (40),
l'axe central (M) de l'aimant permanent (50) s'étend parallèlement au plan d'extension principale du capteur de Hall (40) et l'axe central (M) passe perpendiculairement à travers une normale (N) de la face d'extension principale, dans lequel la normale (N) se trouve au centre de gravité surfacique de la face d'extension principale et les lignes de champ de l'aimant permanent (50) sont essentiellement parallèles à la face d'extension principale du capteur de Hall (40), de telle manière qu'une tension de Hall soit produite lorsqu'une partie des lignes de champ magnétique sont déviées perpendiculairement au plan d'extension principale du capteur de Hall (40) au moyen d'une pièce ferromagnétique (100) et dans un premier mode de réalisation l'aimant permanent (50) n'est formé que sur le côté avant du support métallique (20), dans lequel l'axe central (M) de l'aimant permanent (50) s'étend à l'intérieur de la face d'extension principale du capteur de Hall (40) ou
- la normale (N) s'étend à l'intérieur d'une couche de liaison entre les deux pôles de l'aimant,
ou dans un deuxième mode de réalisation l'aimant permanent (50) n'est formé que sur la face supérieure du corps semi-conducteur (30), dans lequel l'axe central (M) de l'aimant permanent (50) s'étend à l'intérieur de la face d'extension principale du capteur de Hall (40).

2. Capteur de champ magnétique intégré (10) selon la revendication 1, **caractérisé en ce que** la tension de Hall augmente lors de la déviation des lignes de champ magnétique.

3. Capteur de champ magnétique intégré (10) selon la revendication 1 ou la revendication 2, **caractérisé en ce que** le capteur de Hall (40) présente une face latérale formée orthogonalement au plan d'extension principale et l'axe central (M) de l'aimant est disposé perpendiculairement à la face latérale.

4. Capteur de champ magnétique intégré (10) selon l'une quelconque des revendications précédentes, **caractérisé en ce que** le capteur de Hall (40) est réalisé sous forme de capteur de Hall bidimensionnel ou tridimensionnel.

5. Capteur de champ magnétique (10) selon la revendication 5, **caractérisé en ce que** le capteur de Hall (40) est formé dans une deuxième dimension de telle manière par rapport au premier pôle de l'aimant permanent (50) qu'une tension de Hall soit produite même sans la pièce ferromagnétique (100).

6. Capteur de champ magnétique intégré (10) selon l'une quelconque des revendications précédentes, **caractérisé en ce que** le capteur de Hall (40) est formé par une plaque de Hall.

7. Procédé de détermination de la position d'une pièce ferromagnétique (100) avec un capteur de champ magnétique intégré (10), présentant un corps semi-conducteur (30) avec une face supérieure et une face arrière,
un support métallique (20), avec un côté avant et un côté arrière, dans lequel le corps semi-conducteur (30) est assemblé par adhérence par la face arrière au côté avant du support métallique (20),
un capteur de Hall (40), formé sur la face supérieure du corps semi-conducteur (30), avec une face d'extension principale,
un aimant permanent (50), avec un premier pôle magnétique formé le long d'une première face (55) et un axe central (M) formé perpendiculairement à la première face,
dans lequel le support métallique (20), l'aimant permanent (50) et le corps semi-conducteur (30) sont disposés dans un boîtier commun (60) et exactement un capteur de Hall (40) est disposé dans le boîtier (60),
la première face (55) de l'aimant permanent (50) est formée perpendiculairement à la face d'extension principale du capteur de Hall (40) et l'axe central (M) s'étend parallèlement au plan d'extension principale du capteur de Hall (40) et l'axe central (M) passe perpendiculairement à travers la normale de la face d'extension principale, dans le centre de gravité surfacique de la face d'extension principale et les lignes de champ de l'aimant permanent (50) sont essentiellement parallèles à la face d'extension principale du capteur de Hall (40), de telle manière qu'une tension de Hall soit produite lorsqu'une partie des lignes de champ magnétique sont déviées perpendiculairement au plan d'extension principale du capteur de Hall (40) au moyen d'une pièce ferromagnétique (100), dans lequel dans un premier mode de réalisation l'aimant permanent (50) n'est formé que sur le côté avant du support métallique (20), et l'axe central (M) de l'aimant permanent (50) s'étend à l'intérieur de la face d'extension principale du capteur de Hall (40) ou la normale (N) s'étend à l'intérieur d'une couche de liaison entre les deux pôles de l'aimant,
ou dans un deuxième mode de réalisation l'aimant permanent (50) n'est formé que sur la face supérieure du corps semi-conducteur (30), et l'axe central (M) de l'aimant permanent (50) s'étend à l'intérieur de la face d'extension principale du capteur de Hall (40).

8. Procédé selon la revendication 7, **caractérisé en ce que** l'on produit une tension de Hall exclusivement lorsque les lignes de champ magnétique sont déviées.

9. Procédé selon la revendication 7 ou la revendication 8, **caractérisé en ce que** l'on augmente la tension de Hall exclusivement lorsque les lignes de champ magnétique sont déviées.
